# EUROPÄISCHE PATENTSCHRIFT

(11) **EP 2 539 479 B1**
(45) Veröffentlichungstag und Bekanntmachung des Hinweises auf die Patenterteilung: **09.02.2022**
(21) Anmeldenummer: 11712190.5
(22) Anmeldetag: 22.02.2011
(51) Int. Cl.: C23C 14/06, C23C 14/56, C23C 16/44, C30B 23/00, C30B 29/48, C23C 14/54

(54) **VORRICHTUNGEN UND VERFAHREN ZUM ABSCHEIDEN EINER SCHICHT AUF EINEM SUBSTRAT**
DEVICE AND METHOD FOR DEPOSING A LAYER COMPOSED OF AT LEAST TWO COMPONENTS ON A SUBSTRATE
DISPOSITIF ET PROCÉDÉ DE DÉPOT D'UNE COUCHE COMPOSÉE D'AU MOINS DEUX COMPOSANTS SUR UN SUBSTRAT

(30) Priorität: 23.02.2010 EP 10154378
(43) Veröffentlichungstag der Anmeldung: 02.01.2013
(73) Patentinhaber: (CNBM) Bengbu Design & Research Institute for Glass Industry Co., Ltd., Bengbu (CN)
(72) Erfinder: PALM, Jörg, 80797 München (DE); POHLNER, Stephan, 81541 München (DE); JOST, Stefan, 81543 München (DE); HAPP, Thomas, 81825 München (DE)
(74) Vertreter: Ipey
(86) Internationale Anmeldenummer: PCT/EP2011/052609
(87) Internationale Veröffentlichungsnummer: WO 2011/104235

(56) Entgegenhaltungen:
- EP-A2- 0 926 258
- EP-A2- 1 382 714
- JP-A- 2006 222 243
- US-A1- 2002 108 572
- US-A1- 2005 042 376
- US-A1- 2008 118 779
- US-B1- 6 241 477

## Beschreibung

Die Erfindung liegt auf dem technischen Gebiet der Herstellung von Schichtensystemen, insbesondere mit dünnen Schichten, und betrifft eine Vorrichtung und ein Verfahren zum Abscheiden einer aus mindestens zwei Komponenten bestehenden Schicht auf einem Substrat.

Die elektronischen und strukturellen Eigenschaften von Halbleiterschichten aus mehreren Komponenten (z. B. CdS, Cu₂S, CuₓSe_{y}, InₓS_{y}, InₓSe_{y}, ZnS, GaAs etc.) werden stark von der Zusammensetzung der Schicht bestimmt. Bei der Schichtabscheidung z. B. über PVD-Prozesse (Physical Vapour Deposition, physikalische Abscheidung dünner Schichten, z. B. thermisches Verdampfen, Elektronenstrahlverdampfen, Sputtern) kann die Zusammensetzung der Schicht von der Zusammensetzung des Ausgangsmaterials abweichen, insbesondere dann, wenn die Verbindung im gasförmigen Zustand dissoziiert. Durch unterschiedliche Eigenschaften der Komponenten (wie z. B. Masse, chemische Reaktivität, Schmelzpunkt) kann die Schicht durch Verlust einer Komponente auf dem Weg von der Quelle bis zum Substrat eine andere Zusammensetzung haben als das Ausgangsmaterial. Auch kann bereits das Ausgangsmaterial eine andere, als die gewünschte, für die Anwendung optimale Zusammensetzung haben.

Nachfolgend werden folgende Begriffe verwendet: Als Verdampfungsrate wird diejenige betitelt, die den Materialfluss direkt aus der Quelle bezeichnet. Die Abscheiderate oder Abscheidungsrate kennzeichnet die Stoffmenge, die sich pro Zeiteinheit auf dem Substrat niederschlägt. Die Bindungsrate, bzw. Getterrate, bezeichnet wiederum die Menge des Materials, die von einer reaktiven bzw. inerten Fläche aus der Gasphase entnommen wird.

Verbindungen aus mehreren Komponenten (Verbindungshalbleiter) können durch verschiedenste Verfahren als dünne Schichten abgeschieden werden. Beim thermischen Verdampfen wird oft das sog. Ko-Verdampfen (Verdampfen einzelner Komponenten, z. B. zur Herstellung eines Chalkopyritabsorbers aus Cu, In, Ga und Se) angewendet. Um Schichten von hoher Materialqualität zu erzeugen, muss jedoch das Substrat auf hohen Temperaturen gehalten werden (>400°C). Insbesondere bei der Herstellung von Pufferschichten in Dünnfilmsolarzellen sind hohe Substrat-Temperaturen (>250°C) oft schädlich, da sich dünne Schichten bei höheren Temperaturen schon weitgehend durch Diffusion und chemische Reaktionen mit dem darunter liegenden Halbleitermaterial vermischen. Beim Ko-Verdampfen muss auch die Anordnung der Quellen genau festgelegt werden. Zudem sind die Verdampfungsraten sehr genau festzulegen, um die Zusammensetzung der abgeschiedenen Schicht mit einer Genauigkeit im einstelligen Prozentbereich homogen auf großen Flächen einstellen zu können. Verbindungshalbleiter können auch durch Sputtern oder thermisches Verdampfen der Verbindung aus dem Schiffchen, aus Effusionszellen, aus Linearverdampfern oder mit dem Elektronenstrahl hergestellt werden. Hierbei ist die Zusammensetzung der Schicht durch die Zusammensetzung des Ausgangsmaterials und durch Prozessparameter einzustellen. Bekannt sind z. B. Versuche mit Zinkoxid, Zink-Magnesiumoxid, Cadmiumsulfid, Zinksulfid oder Indiumsulfid. Hier werden bessere Ergebnisse bei der Schichtbildung erzielt, als bei Anwendung des Ko-Verdampfens, insbesondere bei niedrigen Temperaturen. Dabei treten jedoch Schwierigkeiten in der Reproduzierbarkeit sowie Langzeitstabilität der Abscheidung auf. Insbesondere hat das Ausgangsmaterial einen deutlichen Einfluss auf die Reproduzierbarkeit und den Wirkungsgrad der Solarzellen. Es ist schwierig, die richtige Zusammensetzung aus dem Verbindungsmaterial zu verdampfen, um eine geeignete Schichtbildung zu gewährleisten. Die Steuerung der Schichtzusammensetzung über die Zusammensetzung des Ausgangsmaterials oder über Verdampfungsparameter wie Quellentemperatur oder Geometrie der Quelle ist kritisch, wenn das Quellenmaterial an einer Komponente verarmt. Dann kann die Langzeitstabilität des Prozesses nicht gewährleistet werden. Oxidische Verbindungshalbleiter wie ZnO, ZnMgO, InSnO (ITO) u.ä. werden oft durch Sputtern oder Elektronenstrahlverdampfen (e-beam-Verdampfen) von Targets aus entsprechend mehrkomponentigen Verbindungen hergestellt. In diesem Fall wird meist eine Abweichung der Schichtzusammensetzung durch Sauerstoffverlust beobachtet. Dieser Sauerstoffverlust kann durch Zugabe von Sauerstoffgas ausgeglichen werden. Die Zusammensetzung der Schicht kann auch über die Zusammensetzung des Targetmaterials eingestellt werden. Beim Sputtern ist die Zusammensetzung in geringem Umfang auch über den Sputterdruck einstellbar. Das führt jedoch nicht zu einem langzeitstabilen Prozess, da sich eine Komponente dann im Target anreichert.

Die US-Patentanmeldung Nr. 2005/0042376 A1 zeigt ein Abscheidungsverfahren, bei dem die Schwefelmenge durch ein für Schwefel selektives Gettermaterial oder eine Kühlfalle verringert wird.

Die US-Patentanmeldung Nr. 2008/0118779 A1 zeigt ein Abscheidungsverfahren, bei dem durch Adsorber überschüssiger Sauerstoff in einer Gasatmosphäre eingefangen wird. Eine Steuerung der Bindungsrate ist nicht möglich. US 6 241 477 B zeigt eine Vorrichtung zum Abscheiden dünner Schichten, umfassend Getterelement aus einem reaktiven Material, das durch Temperatur gesteuert ist.

Die europäische Patentanmeldung EP 0926258 A2 zeigt eine Anordnung, bei der durch ein Gettersystem eine Gasatmosphäre gereinigt werden kann. Eine Steuerung der Bindungsrate ist nicht möglich.

Es ist daher Aufgabe der Erfindung, eine Vorrichtung und ein Verfahren zum Abscheiden einer aus mindestens zwei Komponenten bestehenden Schicht auf einem Gegenstand bereitzustellen, mit welcher bzw. mit welchem eine Abscheidung, also ein Abscheidungsprozess, gezielt steuerbar ist. Ferner soll ein Dünnfilm- (Dünnschicht-) Solarmodul vorgesehen werden. Diese Aufgabe wird durch eine Vorrichtung und ein Verfahren mit den Merkmalen der nebengeordneten Ansprüche gelöst. Vorteilhafte Ausgestaltungen der Erfindung sind durch die Merkmale der Unteransprüche angegeben.

Insbesondere wird die Aufgabe durch eine Vorrichtung zum Abscheiden einer aus mindestens zwei Komponenten bestehenden Schicht, insbesondere einer dünnen Schicht, auf einem Gegenstand, insbesondere auf einem Substrat, gelöst, wobei die Vorrichtung in Anspruch 1 beschrieben ist.

Dabei ist die Einrichtung zum Steuern des Abscheidungsprozesses so ausgebildet, dass die selektiv gebundene Menge der mindestens einen Komponente durch Veränderung zumindest eines Steuerparameters, der mit einer Bindungsrate der Einrichtung für die wenigstens eine Komponente wirkgekoppelt ist, Steuer- bzw. veränderbar ist. Wie eingangs bereits ausgeführt wurde, beschreibt die Bindungsrate der Vorrichtung zum Abscheiden die Menge einer selektiv gebundenen Komponente, die von einer reaktiven bzw. inerten Bindungsfläche pro Zeiteinheit aus der Gasphase entnommen wird. Die Bindungsrate hängt von einem Bindungsvermögen und/oder der Größe der Bindungsfläche ab.

Ein wesentlicher Punkt der Erfindung liegt darin, dass mit der Vorrichtung (und auch mit dem Verfahren) eine Steuerung bzw. Kontrolle der Schichtzusammensetzung beim Abscheiden von Schichten aus mehreren Komponenten, insbesondere auf einem Substrat, möglich ist. Im Rezipienten (d.h. beispielsweise Verdampfungsraum bei Verdampfung bzw. Sputterkammer bei Kathodenzerstäubung) wirkt die Einrichtung zum Steuern mit definierten Parametern, der Abscheideraum ist also derart ausgebildet, dass eine Abscheidung gezielt bzw. kontrolliert stattfindet, weil gezielt die Konzentration mindestens einer Komponente des abzuscheidenden Materials durch vorzeitiges "Abfangen" verändert wird. Kontrolliert heißt also, die Komponenten des abzuscheidenden Materials werden in ihrer Konzentration (zumindest eine der Komponenten) gezielt beeinflusst, um so die Abscheidungsrate auf dem Gegenstand festzulegen. Möglich ist es natürlich auch, mehrere Komponenten gezielt vor der Abscheidung auf dem Substrat in gewünschter Weise zu beeinflussen, also z. B. deren Konzentrationen zu verändern. Mit der Vorrichtung (und auch mit dem Verfahren) lässt sich z.B. mindestens eine Schicht auf einem Gegenstand, insbesondere auf einem Substrat, abscheiden und so z.B. ein Schichtstapel bzw. Mehrschichtkörper herstellen. Der erfindungsgemäße Gegenstand ist insbesondere nützlich beim Verdampfen aus der Verbindung. Es ist aber auch beim Ko-Verdampfen von Vorteil, wenn man die Abscheiderate noch durch einen zusätzlichen Parameter neben den Verdampfungsraten der Einzelelemente steuern kann. Anwendbar ist die Erfindung für alle Beschichtungsverfahren, insbesondere bei PVD-Verfahren und dabei insbesondere bei thermischen Verfahren aus Schiffchen, Tiegeln, Effusionszellen, Linearquellen etc. Weitere Verfahren mit Schichtabscheidung über PVD sind Elektronenstrahlverdampfen, Magnetronsputtern, Ionenstrahlablation oder Laserstrahlablation. Anwendungen mit anderen Verfahren zur Abscheidung dünner Schichten (z.B. CVD, Chemical Vapour Deposition) sind jedoch auch denkbar. Diese Schichten können mit diesem Verfahren auf verschiedensten Gegenständen, insbesondere auf Substraten, abgeschieden werden. Die Abscheiderate kann dabei durch diverse Parameter gesteuert bzw. kontrolliert werden, wie nachfolgend näher beschrieben wird. Der erfindungsgemäße Gegenstand eignet sich so für einen langzeitstabilen Prozess, insbesondere, wenn die gewünschte Schichtzusammensetzung nur wenige Prozent von der jeweils momentan vorhandenen Zusammensetzung des Ausgangsmaterials abweicht. Somit lassen sich der Aufbau der Prozessanlage und die Prozessführung wesentlich einfacher gestalten, als dies bisher möglich war.

Im Folgenden werden meist die chemischen Zeichen für bestimmte Elemente angegeben, beispielsweise "Mo" für Molybdän oder "Se" für Selen.

Vorteilhaft ist in der erfindungsgemäßen Vorrichtung zum Abscheiden einer aus mindestens zwei Komponenten bestehenden Schicht auf einem Gegenstand die Einrichtung zum Steuern des Abscheidungsprozesses so ausgebildet, dass die selektiv gebundene Menge der mindestens einen Komponente (auch) während des Abscheidungsprozesses der Komponente steuerbar ist. Durch diese Maßnahme kann auch während des Abscheidens der Schicht gezielt Einfluss auf die Schichtzusammensetzung genommen werden. Weiterhin kann es in der erfindungsgemäßen Vorrichtung von besonderem Vorteil sein, wenn die Einrichtung zum Steuern des Abscheidungsprozesses so ausgebildet ist, dass die selektiv gebundene Menge der mindestens einen Komponente ohne Änderung eines in der Abscheidekammer erzeugten Unterdrucks steuerbar ist. Durch diese Maßnahme kann in vorteilhafter Weise eine Steuerung bzw. Veränderung der Zusammensetzung der abgeschiedenen Schicht ohne Brechen des Unterdrucks bzw. Vakuums erfolgen, so dass die Herstellung von Schichten wesentlicher einfacher und schneller erfolgen kann. Zudem kann vermieden werden, dass durch ein Brechen des Vakuums in unerwünschter Weise Fremdsubstanzen in die Abscheidkammer eindringen, wodurch die Zusammensetzung (Reinheit) hergestellter Schichten beeinträchtigt sein kann.

Erfindungsgemäß weist die Einrichtung zum Steuern mindestens ein Getterelement aus einem (chemisch) reaktiven Material auf, das in der Abscheidekammer angeordnet ist und das derart ausgebildet ist, dass die Konzentration der mindestens eine Komponente (des abzuscheidenden Materials) durch chemische Bindung einer bestimmten Menge der Komponente an das Getterelement (und damit vor der eigentlichen Abscheidung als Schicht auf dem Substrat) veränderbar ist. Das heißt, durch selektive oder gezielte Bindung von Gasteilchen (Molekülen, Atomen und/oder Ionen) des abzuscheidenden Materials durch mindestens ein Getterelement, welche ein gegenüber der mindestens einen zu steuernden Komponente chemisch reaktives Material aufweist, wird die Zusammensetzung der sich abscheidenden Schicht (und so der abgeschiedenen Schicht) gegenüber der Zusammensetzung des Ausgangsmaterials in der Gasphase abgeändert. Die Schichtbildung kann dementsprechend kontrolliert gesteuert werden.

Bevorzugt kann die Einrichtung zum Steuern auch mindestens ein Getterelement aufweisen, vorzugsweise aus einem gegenüber der mindestens einen zu steuernden Komponente (chemisch) inerten Material, das in der Abscheidekammer angeordnet ist und das derart ausgebildet ist, dass die Konzentration der mindestens einen Komponente durch physikalische Bindung einer bestimmten Menge der Komponente an das Getterelement veränderbar ist. Die selektive Bindung kann hier z.B. durch Kondensation oder Adsorption erfolgen (Steuerung vor allem über die Temperatur der Getterfläche, s. u.). Das heißt, im Rezipienten befinden sich ein oder mehrere Körper, an die sich selektiv (d. h. zum Beispiel gezielt gewählt), über eine chemische oder physikalische Reaktion, eine Komponente des Dampfes (oder auch Plasmas) bindet. Dadurch entsteht eine Differenz zwischen der Zusammensetzung des Dampfes in der Kammer und der Zusammensetzung der Schicht. Das Getterelement ist mit definierten Eigenschaften ausgebildet, so dass die Abscheidung auf diesem selbst und damit auch auf dem Substrat definiert und so gezielt erfolgt. Das abzuscheidende Material wird sich - je nach Ausgestaltung der Umgebung - im Wesentlichen überall absetzen, eben auch auf dem Getterelement oder den Getterelementen. Damit wird ein bestimmter Anteil des abzuscheidenden Materials vor der eigentlichen Abscheidung auf dem Substrat "weggenommen". Das heißt, das Getterelement (oder ggf. mehrere Getterelemente) dient der Änderung der chemischen Zusammensetzung des Dampfes und/oder eines Plasmas. Somit kann die Zusammensetzung der Schicht auf dem Substrat bei der Abscheidung variabel eingestellt werden. Die Bindung von Gasteilchen an das Gettermaterial kann reversibel oder irreversibel erfolgen. Bei reaktivem Gettermaterial wird meist eine irreversible Bindung erzielt und das Getterelement ist von Zeit zu Zeit z.B. zu ersetzen bzw. zu regenerieren.

Vorzugsweise ist das Getterelement aus Kupfer und/oder Molybdän oder einem anderen für die jeweilige Verbindung geeigneten Element ausgebildet, um insbesondere eine chemischen Bindung an dem Getterelement zu erzielen. Bei Verdampfung von Ausgangsmaterialien des Typs BₓC_{y} kann der Anteil y durch Verwendung von Getterflächen im Verdampfungsraum reduziert werden. Kupfer eignet sich besonders gut zur Bindung sulfidischer oder selenidischer Komponenten. Daher sind mit der erfindungsgemäßen Vorrichtung besonders Verbindungen wie Cu₂S, In₂S₃, InS, GaS, Ga₂S₃, Al₂S₃, CuInS₂, CuGaS₂, CuAlS₂, CuIn₅S₈, Cu₂Se, In₂Se₃, GaSe, Ga₂Se₃, Al₂Se₃, CuInSe₂, CuGaSe₂, CuAlSe₂, CuIn₃Se₅, SnSe, SnSe₂, ZnSe, SnS, SnS₂, ZnS, Cu₂SnS₃, CdS, CdSe, CdTe, Cu₂ZnSnS₄, Cu₂ZnSnSe₄ oder andere Verbindungen, insbesondere andere seien-, wohl Kupfer, als auch Molybdän binden bevorzugt Se bzw. S oder Te. Damit verarmt die auf dem Gegenstand oder Substrat sich abscheidende bzw. abgeschiedene Schicht bezüglich dieser Elemente, so dass eine Kontrolle der genauen Zusammensetzung der abgeschiedenen Schicht möglich wird. Auch bei der Abscheidung von oxydischen Verbindungen kann man zum Beispiel den Sauerstoffgehalt der Schicht durch die reaktive Bindung des Sauerstoffs über Getterflächen z. B. aus Ti kontrollieren.

In einer weiteren bevorzugten Ausführungsform ist das Getterelement als explizites Element in der Abscheidekammer angeordnet und/oder bildet mindestens einen Teil der Abscheidekammer, insbesondere mindestens einen Teil einer Abscheidekammerwandung, aus. Das Getterelement kann also an einer dafür vorgesehenen Stelle in der Abscheidekammer angeordnet werden und ist so auch einfach aus dieser wieder entfernbar. Beispielsweise kann das Getterelement in einer ggf. sich ausbildenden Dampfkeule angeordnet werden und so Einfluss auf die Gasphase und damit auf die Schichtbildung nehmen. Möglich ist es auch, die Wände der Abscheidekammer aus dem gewünschten Gettermaterial auszubilden (mindestens teilweise) oder eine Wandauskleidung (ebenfalls mindestens teilweise) aus dem Gettermaterial vorzusehen (platzsparend) .

Erfindungsgemäß umfasst die Einrichtung zum Steuern mindestens ein Blendenelement, das derart ausgebildet ist, dass ein wirksamer Bereich des Getterelements variierbar ist. Das heißt, die dem Dampf ausgesetzte Fläche des Getterelements ist variierbar. Das Blendenelement ist derart angeordnet, dass es das Getterelement z.B. teilweise verdeckt oder den wirksamen Bereich vergrößert. Ist das Blendenelement (oder ggf. sind die Blendenelemente) vollständig zurückgezogen, so kann beispielsweise die gesamte Fläche des Getterelements wirken. Hierfür ist das Blendenelement bzw. sind die Blendenelemente aus inertem Material ausgebildet (so dass eine Getterwirkung im Prinzip vermieden wird). Als Blendenelemente können z. B. Faltenbalge, verschiebbare Abdeckungen und dergleichen Einrichtungen vorgesehen werden. Die wirksame Fläche (Bindungsfläche) des Getterelements, deren Größe hier beispielsweise über ein oder mehrere Blendenelemente veränderbar ist, dient somit als veränderbarer Steuerparameter zur Steuerung der Bindungsrate zum selektiven Binden zumindest einer Komponente der abzuscheidenden Schicht.

In einer vorteilhaften Ausführungsform weist die Einrichtung zum Steuern mindestens eine Einrichtung zur Temperatursteuerung bzw. -regelung auf, die derart ausgebildet ist, dass die Temperatur mindestens des wirksamen Bereichs des Getterelements und/oder des Gegenstands, insbesondere des Substrats, steuerbar ist. Die Einrichtung kann z.B. als eine Quellenheizeinrichtung und/oder eine Substratheizeinrichtung vorgesehen sein oder diese umfassen. Die Temperatur des Getterelements hat Einfluss auf die Getterrate und dient somit als veränderbarer Steuerparameter zur Steuerung der Bindungsrate zum selektiven Binden zumindest einer Komponente der abzuscheidenden Schicht.

Das Ausmaß der Kondensation (in diesem Falle physikalische Bindung) einer Komponente (d. h. einer bestimmten Menge von Gasteilchen an das Getterelement) und damit die Zusammensetzung der Schicht auf dem Substrat kann über die Temperatur der Getterfläche gesteuert werden. Alternativ, als weiterer oder auch als zusätzlicher Parameter zur Steuerung der Abscheidungsrate, eignet sich hier die Substrattemperatur. Durch eine Variation dieser Temperatur wird entweder die Getterrate erhöht oder reduziert, je nach Wahl der Reaktionspartner. Eine Erhöhung der Temperatur kann dabei zur Erhöhung der Getterwirkung oder aber auch zu einer höheren Reemissions-Wahrscheinlichkeit von der heißeren Fläche zurück in die Abscheidekammer und damit zu einer reduzierten Getterwirkung führen. In beiden Fällen kann die Abscheidungsrate und/oder Bindungsrate aber von außen durch einen variablen Prozessparameter kontrolliert werden. In einem Produktionsprozess kann dann in regelmäßigen Wartungsintervallen die Oberfläche durch Aufheizen regeneriert werden. Alternativ dazu könnten die temperierbaren Oberflächen (Bleche, Folien, Gitter o. ä.) ausgetauscht und durch frische unbeschichtete Oberflächen ersetzt werden. Des Weiteren kann über die Temperatur einer nicht inerten Getterfläche die Reaktionsgeschwindigkeit der zu bindenden Komponente beeinflusst werden (in diesem Falle chemische Bindung). Zum Beispiel im Falle einer Kupferfläche in einer schwefelhaltigen Atmosphäre kann durch ein Anheben der Temperatur des Kupfers die Geschwindigkeit der Schwefelkorrosion (d.h. Erhöhung der Schwefel-Bindung an der Kupferfläche) beschleunigt werden, wodurch während eines Abscheidungsprozesses weniger Schwefel in die Schicht eingebaut werden kann.

Vorzugsweise weist die Einrichtung zum Steuern mindestens zwei Getterelemente auf, die als Elektrodenelemente ausgebildet sind und an die unterschiedliche elektrische Potentiale anlegbar sind, so dass zwei unterschiedlich ausgebildete Getterelemente vorgesehen sind, die ggf. unterschiedliche Bindungsraten (Abscheidung auf den Getterelementen) ermöglichen. Möglich ist es auch, ein Getterelement in Bezug auf die Kammerwandung zu verschalten, so dass Getterelement und Kammerwandung auf unterschiedlichen Potentialen liegen. Auch kann hierfür eine weitere Elektrode vorgesehen sein, die die Einrichtung zum Steuern umfasst. Hierfür müsste die Einrichtung zum Steuern entsprechende Schaltungselemente aufweisen, so dass das Anlegen unterschiedlicher Potentiale ermöglicht wird. Eine weitere Möglichkeit, die Dampfzusammensetzung von außen zu steuern, könnte also darin bestehen, z.B. zwei Kupferflächen im Rezipienten auf unterschiedliche elektrische Potentiale zu legen. An zwei Flächen, die eine Potentialdifferenz gegeneinander aufweisen, können unterschiedlich starke Niederschläge festgestellt werden. Durch eine Variation der Potentialdifferenz oder auch der Elektrodenfläche und deren Anordnung könnte somit ebenfalls die Schichtzusammensetzung aktiv gesteuert werden. Alternativ kann auch das elektrische Potential der Cu-Fläche relativ zur Kammerwand oder einer anderen Elektrode in der Prozesskammer verändert werden.

Vorteilhafterweise ist es vorgesehen, dass die Einrichtung zum Steuern mindestens eine Einrichtung zum Verfahren und/oder Positionieren des Getterelements und/oder des Blendenelements aufweist, die derart ausgebildet ist, dass das Getterelement und/oder das Blendenelement in der Abscheidekammer verfahrbar und so die Position des Getterelements und/oder des Blendenelements variierbar ist. Somit lässt sich beispielsweise der wirksame Bereich des Getterelements verändern (z.B. durch das Verfahren des Getterelements hinter ein Blendenelement und/oder innerhalb einer ggf. auftretenden Dampfkeule). Auch kann das Verfahren zum Austauschen des Elements genutzt werden. Das Verfahren des Blendenelements oder mehrerer Blendenelemente erlaubt ebenfalls die Veränderung des wirksamen Bereichs des Getterelements oder der Getterelemente. Ist diese Veränderung des Getterelements beispielsweise eine Funktion vom radialen Abstand zur Achse einer Effusionszelle (oder einer Sputterkathode etc.), so ist es denkbar die Getterwirkung als Funktion des Abstandes zur Verdampfungsachse einzustellen. Diese Funktion kann grundsätzlich genutzt werden, um evtl. auftretende Inhomogenitäten der Dampfkeule verschiedener verdampfender Spezies zu eliminieren. Ebenfalls könnte dieser Effekt genutzt werden, um großflächig homogene Beschichtungen hinsichtlich der Schichtzusammensetzung zu ermöglichen.

Vorzugsweise ist das Getterelement als ein Flächenelement oder ein Stabelement ausgebildet, da sich diese einfach platzieren lassen und auf geeignete Weise einen wirksamen Bereich zur Verfügung stellen. Ebenso kann das Getterelement als Folienelement vorgesehen sein, als Blechelement, als Gitterelement (eindimensional als Rost oder zweidimensional als Netz oder Sieb, auch mit unterschiedlichen Gitterabständen in einer oder zwei Richtungen innerhalb der Gitterebene) oder dergleichen Elemente.

Das Getterelement ist vorzugsweise derart ausgebildet, dass es die mindestens eine Quelle mindestens teilweise umhüllt. Hierfür ist z.B. eine Zylinderform geeignet, oder das Getterelement ist als Kastenelement ausgebildet. Damit wirkt das Getterelement in nächster Nähe zum Verdampfungsort (Quelle).

Vorzugsweise lassen sich mit der Vorrichtung folgende Verbindungen abscheiden:
alle mehrkomponentigen Verbindungen,
- insbesondere II-VI-, III-V-, III₂VI₃-, I-III-VI₂-, I-III₃-VI₅-, I-III₅-VI₈-, I₂-II-IV-VI₄- Verbindungen, wobei die römischen Ziffern I bis VI die entsprechenden Gruppen des periodischen Systems der Elemente bezeichnen,
- insbesondere alle Verbindungen mit Sauerstoff, Schwefel, Selen oder Tellur,
- insbesondere Verbindungen wie Cu₂Se, In₂Se₃, GaSe, Ga₂Se₃, Al₂Se₃, CuInSe₂, CuGaSe₂, CuAlSe₂, CuIn₃Se₅, Cu₂S, In₂S₃, InS, GaS, Ga₂S₃, Al₂S₃, CuInS₂, CuGaS₂, CuAlS₂, CuIn₅S₈, SnSe, SnSe₂, ZnSe, SnS, SnS₂, ZnS, Cu₂SnS₃, CdS, CdSe, Cu₂ZnSnS₄, Cu₂ZnSnSe₄ oder CdTe.

Das heißt, dass z. B. das Getterelement derart ausgebildet ist, dass diese Verbindungen besonders geeignet für den Abscheidungsprozess und für eine Schichtabscheidung auf dem Gegenstand bzw. auf dem Substrat sind.

Die Erfindung erstreckt sich auch auf eine Vorrichtung zum Abscheiden einer aus mindestens zwei Komponenten bestehenden Schicht auf einem Gegenstand, mit einer Abscheidekammer zum Anordnen des Gegenstands, mindestens eine Quelle mit abzuscheidendem Material, sowie mindestens einer Einrichtung zum Steuern des Abscheidungsprozesses, die derart ausgebildet ist, dass die Konzentration mindestens einer Komponente des abzuscheidenden Materials in deren Gasphase vor Abscheidung auf dem Gegenstand durch selektive Bindung einer bestimmten Menge der mindestens einen Komponente veränderbar ist, wobei die Einrichtung zum Steuern des Abscheidungsprozesses mindestens ein Getterelement aus einem reaktiven Material aufweist, das in der Abscheidekammer angeordnet und so ausgebildet ist, dass die Konzentration der mindestens eine Komponente durch chemische und/oder physikalische Bindung einer bestimmten Menge der Komponente an das Getterelement veränderbar ist, wobei das reaktive Material Kupfer und/oder Molybdän bzw. ein oder mehrere Verbindungen hiervon umfasst. Vorteilhaft ist diese Vorrichtung so ausgebildet, dass die selektiv gebundene Menge der mindestens einen Komponente durch Veränderung zumindest eines mit einer Bindungsrate für die wenigstens eine Komponente wirkgekoppelten Steuerparameters steuerbar ist, wobei zu diesem Zweck die Einrichtung zum Steuern des Abscheidungsprozesses so ausgebildet sein kann, dass eine Temperatur und/oder eine wirksame Bindungsfläche und/oder ein elektrisches Potenzial des Getterelements veränderbar ist.

Die Erfindung erstreckt sich auch auf ein Verfahren zum Abscheiden einer aus mindestens zwei Komponenten bestehenden Schicht auf einem Gegenstand, bei welchem die Konzentration mindestens einer Komponente in deren Gasphase vor Abscheidung auf dem Gegenstand durch selektive Bindung einer bestimmten Menge der Komponente mittels einer Einrichtung zum Steuern des Abscheidungsprozesses verändert wird, wobei die selektiv gebundene Menge durch Veränderung einer Bindungsrate für die Komponente der Einrichtung zum Steuern des Abscheidungsprozesses gesteuert wird. Erfindungsgemäß wird die selektiv gebundene Menge der mindestens einen Komponente durch Verändern einer Temperatur und/oder einer wirksamen Bindungsfläche und/oder eines elektrischen Potenzial eines Getterelements gesteuert. Bei einer weiteren vorteilhaften Ausgestaltung des erfindungsgemäßen Verfahrens wird an mindestens zwei Getterelemente, die als Elektrodenelemente ausgebildet sind, ein unterschiedliches elektrisches Potenzial angelegt, um die Zusammensetzung der abgeschiedenen Schicht in gewünschter Weise gezielt zu steuern. Bei einer weiteren vorteilhaften Ausgestaltung des erfindungsgemäßen Verfahrens wird an das mindestens eine Getterelement in Bezug auf eine Wandung der Abscheidekammer ein unterschiedliches elektrisches Potential angelegt, um die Zusammensetzung der abgeschiedenen Schicht in gewünschter Weise gezielt zu steuern. Bei einer weiteren vorteilhaften Ausgestaltung des erfindungsgemäßen Verfahrens wird an das Getterelement in Bezug auf mindestens eine weitere Elektrode ein unterschiedliches elektrisches Potential angelegt, um die Zusammensetzung der abgeschiedenen Schicht in gewünschter Weise gezielt zu steuern. Bei einer weiteren vorteilhaften Ausgestaltung des erfindungsgemäßen Verfahrens wird das mindestens eine Getterelement und/oder ein Blendenelement für Getterelement in der Abscheidekammer verfahren und so die Position des Getterelements und/oder des Blendenelements variiert, um die Zusammensetzung der abgeschiedenen Schicht in gewünschter Weise gezielt zu steuern.

Gezeigt ist auch ein Verfahren zum Abscheiden einer aus mindestens zwei Komponenten bestehenden Schicht, insbesondere einer dünnen Schicht, auf einem Gegenstand, insbesondere auf einem Substrat, mit einer Vorrichtung, die Folgendes umfasst:
eine Abscheidekammer und mindestens eine Quelle mit abzuscheidendem Material, die insbesondere in der Abscheidekammer anordenbar oder angeordnet ist, sowie mindestens eine Einrichtung zum Steuern des Abscheidungsprozesses, wobei das Verfahren folgende Schritte umfasst:
- Anordnen des Gegenstandes, insbesondere des Substrats, in der Abscheidekammer,
- Steuern des Abscheidungsprozesses mittels der mindestens einen Einrichtung zum Steuern derart, dass durch diese mindestens die Konzentration mindestens einer Komponente des abzuscheidenden Materials in deren Gasphase und somit vor deren Abscheidung auf dem Gegenstand, insbesondere auf dem Substrat, durch selektive Bindung einer bestimmten Menge der mindestens einen Komponente veränderbar ist, so dass die Abscheidung kontrolliert erfolgt.

Vorzugsweise umfasst die Einrichtung zum Steuern mindestens ein Getterelement aus einem reaktiven Material, das in der Abscheidekammer angeordnet ist. Vorzugsweise ist der weitere Schritt vorgesehen: Verändern der Konzentration der mindestens einen Komponente mittels des Getterelements aus dem (chemisch) reaktiven Material, durch chemische Bindung einer bestimmten Menge der Komponente an das Getterelement. Ebenfalls vorzugsweise weist die Einrichtung zum Steuern mindestens ein Getterelement aus einem inerten Material auf, das in der Abscheidekammer angeordnet ist, und vorzugsweise ist der weitere Schritt vorgesehen: Verändern der Konzentration der mindestens einen Komponente mittels des Getterelements aus dem (chemisch) inerten Material, durch physikalische Bindung einer bestimmten Menge der Komponente an das Getterelement.

Wie bereits oben beschrieben kann durch das physikalische oder chemische Binden von Gasteilchen an das Gettermaterial das verdampfende Material, das heißt, die Konzentration des Materials, gezielt variiert werden (mindestens von einer Komponente des verdampfenden und abzuscheidenden Materials), um so den Schichtbildungsprozess auf dem Gegenstand, insbesondere auf dem Substrat, steuern bzw. kontrolliert ablaufen lassen zu können. Hierfür kann vorzugsweise auch der weitere Schritt des Variierens eines wirksamen Bereichs des Getterelements mittels mindestens eines Blendenelements der Einrichtung zum Steuern vorgesehen sein. Auch kann vorzugsweise der Schritt des Steuerns der Temperatur vorgesehen sein, und zwar der Temperatur mindestens des wirksamen Bereichs des Getterelements und/oder des Gegenstands, insbesondere des Substrats, mittels einer Einrichtung zur Temperatursteuerung oder -regelung der Einrichtung zum Steuern. Das Verändern des wirksamen Bereichs des Getterelements und/oder das Verändern der Temperatur des wirksamen Bereichs oder auch der Substrattemperatur sind ebenfalls Maßnahmen, um den Schichtbildungsprozess auf dem Substrat selektiv ablaufen zu lassen und gezielt zu beeinflussen, da eine unterschiedliche Temperatur des Getterelements und/oder des Substrats eine unterschiedliche Bindung an das Getterelement einer Komponente und auch ein unterschiedliches Abscheiden auf dem Substrat der Komponente bzw. der Komponenten bewirkt. Geeignet ist auch der weitere Schritt des Anlegens unterschiedlicher elektrischer Potentiale an zwei Getterelemente, um den Abscheidungsprozess auf das Substrat zu steuern (indem die Konzentration des abzuscheidenden Materials in der Gasphase beeinflusst also verändert wird). Hierfür umfasst die Einrichtung zum Steuern eben mindestens zwei Getterelemente, die als Elektrodenelemente ausgebildet sind und die entsprechend verschaltet werden können. Auch kann ein Getterelement mit der Abscheidekammerwandung oder mit einer zusätzlichen Elektrode derart verschaltet werden, dass Getterelement und Wandung oder Getterelement und zusätzliche Elektrode auf unterschiedlichen Potentialen liegen.

Vorzugsweise ist der weitere Schritt vorgesehen: Verfahren (Änderung der Position) des Getterelements und/oder des Blendenelements in der Abscheidekammer und damit Variieren des wirksamen Bereichs des Getterelements mittels einer Einrichtung zum Verfahren und/oder Positionieren des Getterelements und/oder des Blendenelements der Einrichtung zum Steuern. Dies ermöglicht die gewünschte Platzierung des Getterelements und/oder des Blendenelements an einer für die Einwirkung auf das abzuscheidende Material geeigneten Stelle und auch die Positionierung zur Veränderung des wirksamen Bereichs des Getterelements. Schließlich kann es vorteilhaft sein, den folgenden weiteren Schritt vorzusehen: Umhüllen der Quelle der Vorrichtung mittels des Getterelements. Vorzugsweise ist der Schritt vorgesehen: Abscheiden folgender Verbindungen (das heißt, alle diese Komponenten lassen sich wahlweise mit dem erfindungsgemäßen Verfahren abscheiden):
alle mehrkomponentigen Verbindungen,
- insbesondere II-VI-, III-V-, III₂VI₃-, I-III-VI₂-, I-III₃-VI₅-, I-III₅-VI₈-, I₂-II-IV-VI₄- Verbindungen,
- insbesondere alle Verbindungen mit Sauerstoff, Schwefel, Selen oder Tellur,
- insbesondere Verbindungen wie Cu₂Se, In₂Se₃, GaSe, Ga₂Se₃, Al₂Se₃, CuInSe₂, CuGaSe₂, CuAlSe₂, CuIn₃Se₅, Cu₂S, In₂S₃, InS, GaS, Ga₂S₃, Al₂S₃, CuInS₂, CuGaS₂, CuAlS₂, CuIn₅S₈, SnSe, SnSe₂, ZnSe, SnS, SnS₂, ZnS, Cu₂SnS₃, CdS, CdSe, Cu₂ZnSnS₄, Cu₂ZnSnSe₄ oder CdTe.

Gezeigt ist auch ein Dünnfilm-Solarmodul bzw. Dünnschicht-Solarmodul mit einem Schichtstapel (Mehrschichtkörper, z. B. Substrat mit darauf abgeschiedener Schicht bzw. abgeschiedenen Schichten), wobei der Schichtstapel oder zumindest eine Schicht des Schichtstapels mit dem oben beschriebenen Verfahren hergestellt ist bzw. wurde.

Des Weiteren erstreckt sich die Erfindung auf die Verwendung einer solchen Vorrichtung und eines solchen Verfahrens zum Abscheiden einer aus mindestens zwei Komponenten bestehenden Schicht auf einem Gegenstand zur Herstellung einer Dünnschichtsolarzelle bzw. Dünnschichtsolarmoduls, welche vorzugsweise als Halbleiterschicht eine Chalkopyritverbindung, insbesondere Cu(In,Ga)(S,Se)₂, enthält. Vorzugsweise dient die Verwendung zur Herstellung einer CIS- bzw. (CIGSSe)-Dünnschichtsolarzelle bzw. eines CIS bzw. (CIGSSe)-Dünnschichtsolarmoduls

Es versteht sich, dass die verschiedenen Ausgestaltungen der erfindungsgemäßen Gegenstände einzeln oder in beliebigen Kombinationen realisiert sein können. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Nachfolgend wird die Erfindung anhand von Ausführungsbeispielen beschrieben, die anhand der Abbildungen näher erläutert werden. Hierbei zeigen:
- Fig. 1: eine schematische Draufsicht der erfindungsgemäßen Vorrichtung in einer Ausführungsform;
- Fig. 2: eine Dampfdruckkurve von Schwefel;
- Fig. 3: ein Diagramm mit Messkurven eines S₂-Partialdrucks;
- Fig. 4: ein Diagramm zur Darstellung eines Verlaufs des S-Anteils innerhalb einer dünnen Schicht;
- Fig. 5: eine schematische Draufsicht der erfindungsgemäßen Vorrichtung in einer weiteren Ausführungsform;
- Fig. 6: eine schematische Draufsicht der erfindungsgemäßen Vorrichtung in einer weiteren Ausführungsform;
- Fig. 7: eine schematische Draufsicht der erfindungsgemäßen Vorrichtung in einer weiteren Ausführungsform;
- Fig. 8: eine schematische Draufsicht der erfindungsgemäßen Vorrichtung in einer weiteren Ausführungsform;
- Fig. 9: einen Schichtstapel einer Dünnfilm-Solarzelle;
- Fig. 10: einen weiteren Schichtstapel einer Dünnfilm-Solarzelle.

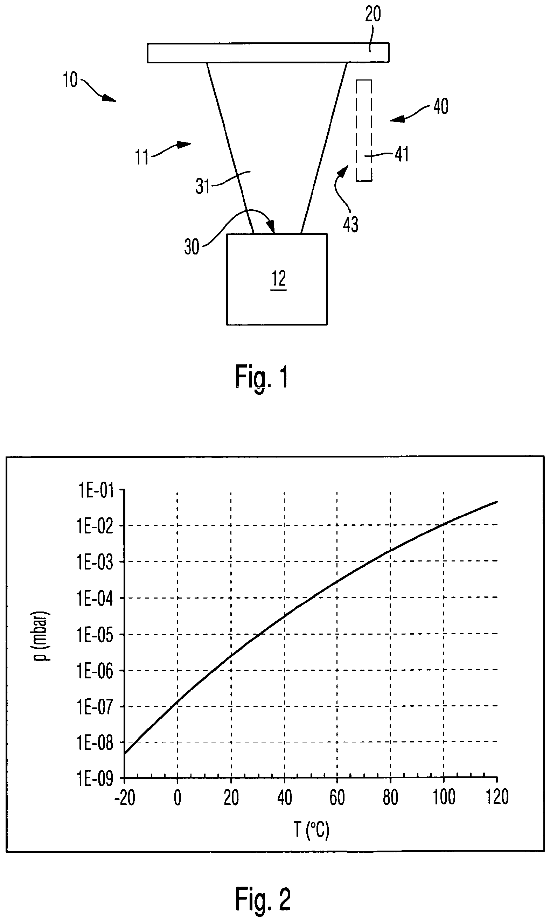

Fig. 1 zeigt eine Vorrichtung 10 zum Abscheiden einer aus mindestens zwei Komponenten bestehenden Schicht, insbesondere einer dünnen Schicht, auf einem Gegenstand, insbesondere auf einem Substrat 20. Dargestellt ist eine schematische Draufsicht. Die Anordnung umfasst eine Abscheidekammer 11 (nicht explizit vorgegeben) und eine Quelle 12 (hier ein Verdampfer) mit abzuscheidendem Material 30, die in der Abscheidekammer 11 angeordnet ist. In dieser Anlage 10 ist ein Substrat 20 oder sind mehrere Substrate (oder allgemein Gegenstände) anordenbar, die beschichtet werden sollen. Zum Beschichten muss das abzuscheidende Material 30 (nicht sichtbar in der Quelle) z. B. verdampft werden. Hierzu wird das abzuscheidende Material 30 z. B. in der Quelle 12 erhitzt (thermisches Verdampfen) und setzt sich so an Gegenständen in der Umgebung ab. Zwischen Quelle 12 und Substrat 20 ist eine Dampfkeule 31 zu erkennen, die durch das abzuscheidende Material 30 in der Gasphase gebildet wird. Andere Gasbildungsverfahren können ebenfalls angewendet werden. Die Vorrichtung (und auch das entsprechende Verfahren) können bei Schichtabscheidung über PVD- oder auch über CVD-Verfahren angewendet werden. Als Quellen können auch Sputterkathoden, Effusionszellen, Tiegel (je nach angewandtem Verfahren) vorgesehen sein.

Die Zusammensetzung der Schicht, die auf dem Substrat 20 abgeschieden werden soll, kann mit dieser Anordnung gezielt beeinflusst werden. Hierzu umfasst die Vorrichtung 10 eine Einrichtung 40 zum Steuern des Abscheidungsprozesses, die derart ausgebildet ist, dass durch diese mindestens die Konzentration mindestens einer Komponente des abzuscheidenden Materials in der Gasphase und somit vor deren Abscheidung durch selektive Bindung (an einen anderen Gegenstand als das Substrat) einer definierten Menge der mindestens einen Komponente veränderbar ist, so dass die Abscheidung auf das Substrat 20 kontrolliert erfolgt. Konkret befindet sich im Rezipienten 11 (d. h. im Verdampfungsraum bei Verdampfung bzw. Sputterkammer bei Kathodenzerstäubung) ein Körper, hier ein Getterelement 41, an das sich selektiv, über eine chemische oder physikalische Reaktion, eine Komponente des Dampfes bindet. Dadurch entsteht eine Differenz zwischen der Zusammensetzung des Dampfes direkt an der Quelle 12 und der Zusammensetzung der Schicht. Das Getterelement ist hier, zur besseren Unterscheidung von den übrigen Bauteilen, mit gestrichelten Linien dargestellt. Das Material setzt sich also auch auf dem Getterkörper bzw. auf dem Getterelement 41 ab. Da das Getterelement 41 mit vorgegebenen Parametern bzw. definierten Eigenschaften ausgebildet ist, erfolgt auch die Abscheidung von Teilchen des abzuscheidenden Materials auf dem Substrat 20 gezielt. Je nach Material des Getters bindet sich das abzuscheidende Material am Getterelement 41 physikalisch oder chemisch.

Die Bindungsrate an dem Getterelement 41 kann durch die Größe der Oberfläche der wirksamen Fläche bzw. des wirksamen Bereichs 43 des Getterelements oder durch weitere physikalische Parameter wie die Temperatur oder ein zusätzliches elektrisches Potential kontrolliert werden. Die Bindung an das Getterelement 41 kann reversibel oder irreversibel sein.

Die Schichten können mit der erfindungsgemäßen Vorrichtung und dem erfindungsgemäßen Verfahren auf verschiedenen Substraten abgeschieden werden. Die Substrate können sowohl flexibel (z. B. Polymer- oder Metallfolien) als auch starr (z. B. Keramik, Glas) ausgebildet sein.

Eine physikalische Bindung (z. B. Adsorption) an das Getterelement 41 kann zum Beispiel über die Temperatur einer inerten Oberfläche (des Getterelements) im Verdampfungsraum gesteuert werden. Fig. 2 zeigt als Beispiel die Dampfdruckkurve von Schwefel. An der Abszisse ist die Temperatur in °C aufgetragen, an der Ordinate der Dampfdruck in mbar. Durch Variation der Temperatur (auch eines chemisch inerten Getterelements) im Bereich von -20°C bis 20°C variiert der Dampfdruck von Schwefel um mehr als drei Größenordnungen. Über eine große Oberfläche im Verdampfungsraum kann der Dampfdruck im Gasraum zwischen Quelle und Substrat deutlich beeinflusst werden. An den Oberflächen wird entsprechend der Temperatur Schwefel kondensieren. Das Getterelement kann auch einen chemisch reaktiven Bereich aufweisen bzw. aus chemisch reaktivem Material ausgebildet sein, z. B. aus Kupfer (Cu-Fläche). Hier wird die Konzentration der mindestens einen Komponente durch chemische Bindung einer bestimmten Menge der Komponente an das Getterelement verändert.

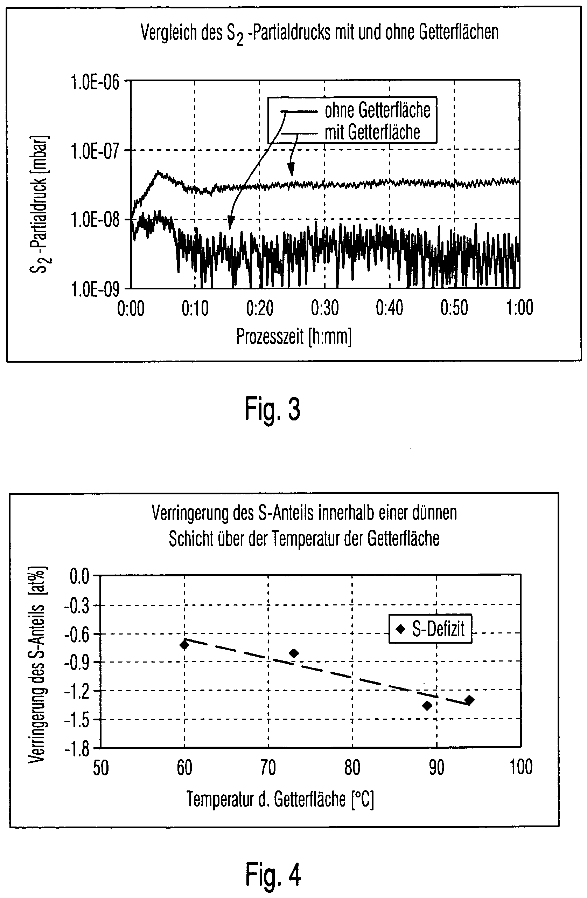

Fig. 3 zeigt ein Diagramm, das Verläufe eines S₂-Partialdrucks über die Zeit in einem Rezipienten darstellt, erfasst in einer Vorrichtung zum Abscheiden mit und ohne Getterelement. Hierfür wurde eine mehrkomponentige, schwefelhaltige Verbindung auf einem Substrat abgeschieden. Auf der Abszisse ist die Prozesszeit in Stunden und Minuten aufgetragen, auf der Ordinate ist der S₂-Partialdruck in mbar aufgetragen. Die Schichtzusammensetzung der abgeschiedenen Schicht auf dem Substrat wurde mit Röntgenfluoreszenzanalyse bestimmt. Dabei zeigte sich, dass der Einbau einer Kupferfolie (als Getterelement) den relativen Schwefelgehalt der abgeschiedenen Schicht um etwa 3% verringert (um die Zusammensetzung der Schicht zu beeinflussen, wurde die Innenseite der Kammerwand der Abscheidungskammer bzw. des Beschichtungsraums mit größeren Flächen der oben erwähnten Kupferfolie ausgekleidet). Ein in der Anlage befindlicher Restgasanalysator wurde benutzt, um den Schwefelpartialdruck zu bestimmen. Man sieht, dass durch die Anwesenheit der Kupferfläche der S₂-Partialdruck um eine Größenordung abgenommen hat. Dies wirkt sich auf die Schichtzusammensetzung der abgeschiedenen Schicht aus.

In weiteren Versuchen wurden die eingebrachten Cu-Flächen (bzw. Getterelemente) beheizt. Fig. 4 zeigt den Verlauf des S-Anteils innerhalb einer dünnen Schicht über der Temperatur des Getterelements. Auf der Abszisse ist also die Temperatur des Getterelements in °C aufgetragen, auf der Ordinate die Verringerung des S-Anteils in der abgeschiedenen Schicht auf dem Substrat in Atom-%. Auch in diesem Fall wurde die Schicht durch Abscheidung einer schwefelhaltigen, mehrkomponentigen Verbindung hergestellt. Es ist zu erkennen, dass durch die Beheizung der oben beschriebenen Cu-Flächen der Schwefelgehalt in der Schicht abnimmt, das heißt die Getterwirkung der Folie nimmt durch das Heizen zu.

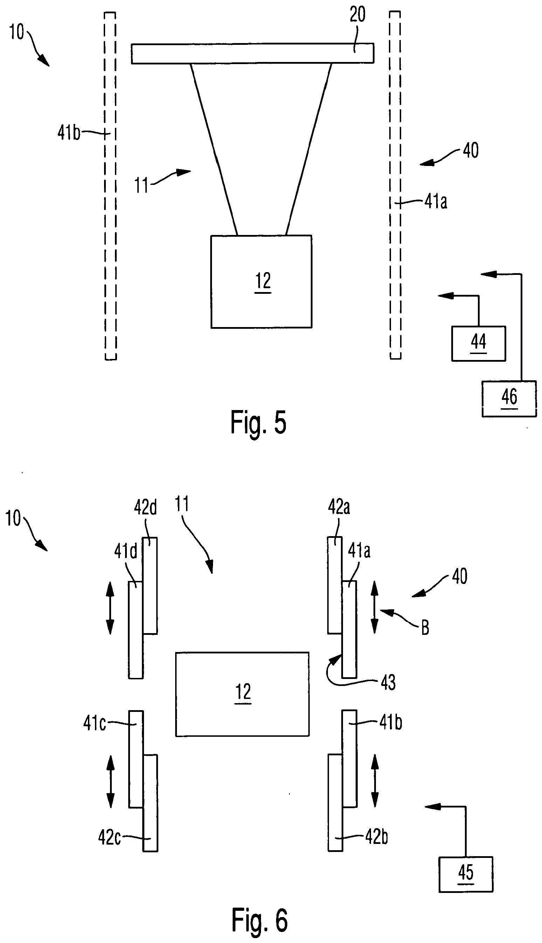

Fig. 5 zeigt in schematischer Draufsicht eine weitere Ausführungsform der erfindungsgemäßen Vorrichtung 10 zum Abscheiden einer Schicht auf einem Gegenstand 20. Diese ist ähnlich wie die in Fig. 1 gezeigte aufgebaut. Allerdings sind hier zwei Getterelemente 41a, 41b vorgesehen, die als Platten (auch Bleche, Folien etc.) an der Rezipientenwand angebracht sind. Die gesamte Wandung der Abscheidekammer 11 kann hierfür genutzt werden (Seitenwände, Boden und/oder Decke) oder nur Teilbereiche davon, je nach gewünschter Wirkung des Getterelements oder der Getterelemente 41a, 41b. Die Platten 41a, 41b können geheizt, gekühlt oder auf unterschiedliche elektrische Potentiale in Bezug zueinander oder in Bezug auf die Kammerwand oder einer anderen Elektrode gelegt werden. Hierfür wären entsprechende Elemente bzw. Einrichtungen vorzusehen. So kann die Einrichtung 40 zum Steuern mindestens eine Einrichtung 44 zur Temperatursteuerung und/oder -regelung aufweisen. Diese ist hier als "Black Box" dargestellt und deutet die Einrichtung 44 schematisch an. Die Einrichtung 40 zum Steuern würde hier dann entsprechende Steuerelemente zur Bedienung der Einrichtung 44 aufweisen. Auch kann die Einrichtung 40 eine Einrichtung 46 zum Verschalten der Getterelemente 41, 41b aufweisen, mit welcher die oben beschriebene Potentialzuordnung ermöglicht wird. Die Einrichtung 46 erlaubt also das Verschalten der beiden Getterelemente, ggf. auch das Verschalten eines Getterelements mit der Wandung der Abscheidekammer oder mit einer zusätzlichen Elektrode.

Fig. 6 zeigt eine weitere Ausführungsform der erfindungsgemäßen Vorrichtung (schematische Draufsicht, ohne Darstellung des Substrats), wobei hier vier Getterelemente 41a, 41b, 41c, 41d vorgesehen sind. Jedes dieser Getterelemente ist mittels eines Blendenelements 42a, 42b, 42c, 42d abdeckbar. Das heißt, jedes der Blendenelemente ist z. B. verschiebbar (in Richtung des Pfeils B), so dass ein wirksamer Flächenbereich 43 (nur bei Getterelement 41a eingezeichnet) von jedem Getterelement 41a, 41b, 41c, 41d variierbar ist. Auch ließen sich die Getterelemente verfahrbar gestalten. Hierfür könnte eine Einrichtung 45 zum Verfahren und /oder Positionieren des Getterelements und/oder des (jeweiligen) Blendenelements vorgesehen sein. Die Einrichtung 45 ist wiederum nur schematisch als "Black Box" dargestellt und soll andeuten, dass die Einrichtung 40 zum Steuern die Einrichtung 45 zum Verfahren aufweisen kann. Die Einrichtung 45 könnte z. B. Schienenelemente aufweisen, in welcher die Blendenelemente und/oder auch die Getterelemente verfahrbar wären, manuell oder automatisiert. Die Einrichtungen 44, 45 und 46 lassen sich in jeder der gezeigten Ausführungsformen vorsehen, wobei die Einrichtung 40 zum Steuern dann mit entsprechenden Steuerungseinrichtungen ausgebildet ist bzw. wobei die Getterelemente entsprechende Anschlussbuchsen etc. aufweisen.

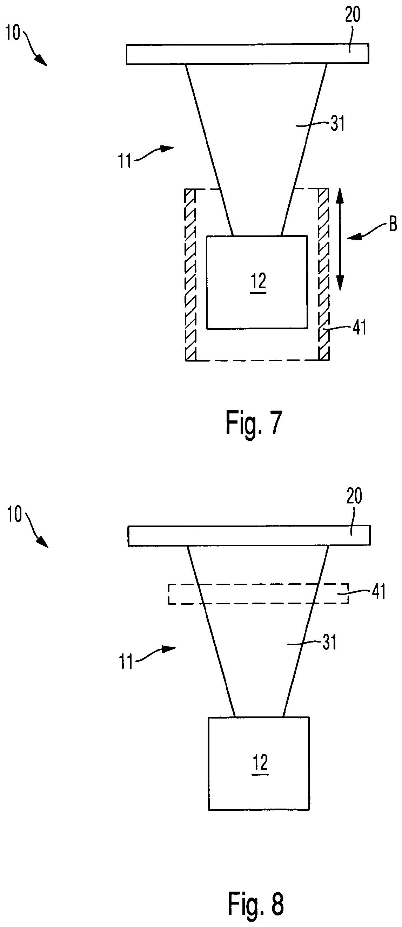

Auch Fig. 7 zeigt eine schematische Draufsicht einer weiteren Ausführungsform der erfindungsgemäßen Vorrichtung 10. Diese ist wiederum ähnlich wie diejenige in Fig. 1 aufgebaut, die Quelle 12 ist aber z. B. eine Effusionszelle. Ein Getterelement 41 ist hier um die Quelle 12 herum angeordnet. Das Getterelement 41 ist hier z. B. zylindrisch ausgebildet (daher ist ein Schnitt gezeigt), kann aber auch elliptisch, rechteckig, sechseckig etc. ausgebildet sein. Auch das umhüllende Getterelement 41 kann geheizt, gekühlt oder geteilt auf unterschiedliches elektrisches Potential gelegt werden. Durch Verschieben des umhüllenden Getterelements (z. B. des umhüllenden Getterzylinders) entlang des Pfeils B kann die effektiv wirksame Fläche variiert werden.

Fig. 8 zeigt eine weitere Ausführungsform der erfindungsgemäßen Vorrichtung (schematische Draufsicht), ähnlich wie die zuvor beschriebenen. Die Quelle 12 ist wiederum eine Verdampferquelle. Hier ist jedoch ein gitterförmiges Getterelement 41 in der Dampfkeule angeordnet. Das Gitter (eindimensional als Rost oder zweidimensional als Netz oder Sieb) liegt also im Dampf"strahl". Das Gitterelement kann ebenfalls geheizt, gekühlt oder auf ein anderes Potential gelegt werden (in Bezug z. B. auf die Kammerwandung). In einer alternativen Ausführungsform kann die Fläche des Gitterelements über eine Änderung des Gitterstababstandes variiert werden.

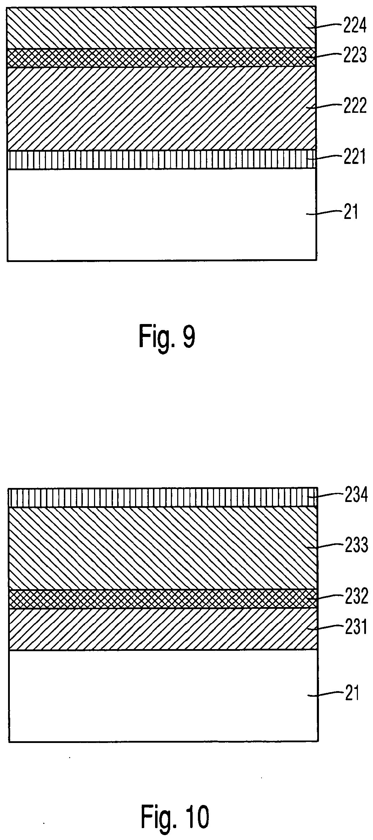

Mit den Figuren 9 und 10 sind beschichtete Substrate 20 gezeigt, wie sie mit der erfindungsgemäßen Vorrichtung 10 bzw. mit dem erfindungsgemäßen Verfahren hergestellt werden können. Fig. 9 zeigt einen Schichtstapel einer Dünnfilm-Solarzelle basierend auf Cu(In, Ga)(S,Se)₂-Absorber. Das "nackte" Substrat 21 kann z. B. aus Glas, Fe, Al oder Kunststofffolie ausgebildet sein, optional mit Diffusionsbarriere. Auf dem Substrat ist eine Mo-Schicht 221 abgeschieden. Danach folgt die Cu(In,Ga)(S,Se)₂-Schicht 222, anschließend eine Pufferschicht 223 und schließlich z. B. eine TCO-Schicht (Transparent Conductive Oxide Layer) 224, z. B. ZnO:Al. Statt der Cu(In,Ga)(S,Se)₂-Schicht kann auch eine Cu₂ZnSn(S,Se)₄-Schicht, eine Cu₂ZnSnS₄-Schicht oder auch eine Cu₂ZnSnSe₄-Schicht vorgesehen werden. Fig. 10 zeigt einen Schichtstapel einer Dünnfilm-Solarzelle, basierend auf CdTe-Absorber und CdS-Puffer. Das Glassubstrat 21 kann z. B. optional mit einer Diffusionsbarriere ausgebildet sein. Danach folgen eine TCO-Schicht (z. B. SnO/ITO etc.) 231, eine CdS-Pufferschicht 232, eine CdTe-Absorberschicht 233 und schließlich ein Interface/Metallkontakt 234.

Mit dem erfindungsgemäßen Gegenstand kann auf einfache Weise gezielt eine Komponente einer auf einem Gegenstand abzuscheidenden Verbindung noch vor der Abscheidung in ihrer Konzentration verändert werden, so dass der Abscheidungsprozess steuerbar ist und eine definierte Schicht auf dem Gegenstand, insbesondere auf dem Substrat, abgeschieden wird. Die Vorrichtung und das Verfahren sind nicht beschränkt auf Substrat- und Kammergröße.

Weitere Merkmale der Erfindung ergeben sich aus der folgenden Beschreibung:
Die Erfindung bezieht sich auf eine Vorrichtung zum Abscheiden einer aus mindestens zwei Komponenten bestehenden Schicht, insbesondere einer dünnen Schicht, auf einem Gegenstand, insbesondere auf einem Substrat, umfassend: eine Abscheidekammer, in der der Gegenstand anordenbar ist; mindestens eine Quelle mit abzuscheidendem Material, die insbesondere in der Abscheidekammer anordenbar oder angeordnet ist; mindestens eine Einrichtung zum Steuern des Abscheidungsprozesses, die derart ausgebildet ist, dass durch diese mindestens die Konzentration mindestens einer Komponente des abzuscheidenden Materials in deren Gasphase und somit vor deren Abscheidung auf dem Gegenstand, insbesondere auf dem Substrat, durch selektive Bindung einer bestimmten Menge der mindestens einen Komponente veränderbar ist, so dass die Abscheidung kontrolliert erfolgt. Gemäß einer Ausgestaltung weist die Einrichtung zum Steuern mindestens ein Getterelement aus einem reaktiven Material auf, das in der Abscheidekammer angeordnet ist und das derart ausgebildet ist, dass die Konzentration der mindestens eine Komponente durch chemische Bindung einer bestimmten Menge der Komponente an das Getterelement veränderbar ist. Gemäß einer Ausgestaltung weist die Einrichtung zum Steuern mindestens ein Getterelement auf, vorzugsweise aus inertem Material, das in der Abscheidekammer angeordnet ist und das derart ausgebildet ist, dass die Konzentration der mindestens eine Komponente durch physikalische Bindung einer bestimmten Menge der Komponente an das Getterelement veränderbar ist. Gemäß einer Ausgestaltung ist das Getterelement als explizites Element in der Abscheidekammer angeordnet und/oder bildet mindestens einen Teil der Abscheidekammer, insbesondere mindestens einen Teil einer Abscheidekammerwandung, aus. Gemäß einer Ausgestaltung umfasst die Einrichtung zum Steuern mindestens ein Blendenelement, das derart ausgebildet ist, dass ein wirksamer Bereich des Getterelements variierbar ist. Gemäß einer Ausgestaltung weist die Einrichtung zum Steuern mindestens eine Einrichtung zur Temperatursteuerung und/oder -egelung auf, die derart ausgebildet ist, dass die Temperatur mindestens des wirksamen Bereichs des Getterelements und/oder des Gegenstands, insbesondere des Substrats steuerbar ist. Gemäß einer Ausgestaltung weist die Einrichtung zum Steuern mindestens zwei Getterelemente auf, die als Elektrodenelemente ausgebildet sind, an die unterschiedliche elektrische Potentiale anlegbar sind, so dass zwei unterschiedlich ausgebildete Getterelemente vorgesehen sind. Gemäß einer Ausgestaltung ist die Einrichtung zum Steuern derart ausgebildet, dass an das Getterelement in Bezug auf die Abscheidekammerwandung ein unterschiedliches elektrisches Potential anlegbar ist. Gemäß einer Ausgestaltung weist die Einrichtung zum Steuern mindestens eine Elektrode auf und ist derart ausgebildet, dass an das Getterelement in Bezug auf diese Elektrode ein unterschiedliches elektrisches Potential anlegbar ist. Gemäß einer Ausgestaltung weist die Einrichtung zum Steuern mindestens eine Einrichtung zum Verfahren und /oder Positionieren des Getterelements und/oder des Blendenelements auf, die derart ausgebildet ist, dass das Getterelement und/oder das Blendenelement in der Abscheidekammer verfahrbar und so die Position des Getterelements und/oder des Blendenelements variierbar ist. Gemäß einer Ausgestaltung ist das Getterelement als ein Flächenelement oder ein Stabelement und/oder als ein Gitterelement ausgebildet, und/oder dass das Getterelement derart ausgebildet, dass es die Quelle mindestens teilweise umhüllt. Gemäß einer Ausgestaltung ist die Vorrichtung derart ausgebildet, dass folgende Verbindungen abscheidbar sind:
alle mehrkomponentigen Verbindungen,
- insbesondere II-VI-, III-V-, III₂VI₃-, I-III-VI₂-, I-III₃-VI₅-, I-III₅-VI₈-, I₂-II-IV-VI₄-Verbindungen,
- insbesondere alle Verbindungen mit Sauerstoff, Schwefel, Selen oder Tellur,
- insbesondere folgende Verbindungen: Cu₂Se, In₂Se₃, Ga-Se, Ga₂Se₃, Al₂Se₃, CuInSe₂, CuGaSe₂, CuAlSe₂, CuIn₃Se₅, Cu₂S, In₂S₃, InS, GaS, Ga₂S₃, Al₂S₃, CuInS₂, CuGaS₂, CuAlS₂, CuIn₅S₈, SnSe, SnSe₂, ZnSe, SnS, SnS₂, ZnS, Cu₂SnS₃, CdS, CdSe, Cu₂ZnSnS₄, Cu₂ZnSnSe₄ oder CdTe.

Die Erfindung bezieht sich auf ein Verfahren zum Abscheiden einer aus mindestens zwei Komponenten bestehenden Schicht, insbesondere einer dünnen Schicht, auf einem Gegenstand, insbesondere auf einem Substrat, mit einer Vorrichtung, die Folgendes umfasst: eine Abscheidekammer; mindestens eine Quelle mit abzuscheidendem Material, die insbesondere in der Abscheidekammer anordenbar oder angeordnet ist; mindestens eine Einrichtung zum Steuern des Abscheidungsprozesses, wobei das Verfahren folgende Schritte umfasst: Anordnen des Gegenstandes, insbesondere des Substrats, in der Abscheidekammer (11); Steuern des Abscheidungsprozesses mittels der mindestens einen Einrichtung zum Steuern derart, dass durch diese mindestens die Konzentration mindestens einer Komponente des abzuscheidenden Materials in deren Gasphase und somit vor deren Abscheidung auf dem Gegenstand, insbesondere auf dem Substrat, durch selektive Bindung einer bestimmten Menge der mindestens einen Komponente veränderbar ist, so dass die Abscheidung kontrolliert erfolgt. Gemäß einer Ausgestaltung weist die Einrichtung zum Steuern mindestens ein Getterelement aus einem reaktiven Material und/oder aus einem vorzugsweise inerten Material auf, das in der Abscheidekammer angeordnet ist, wobei das Verfahren den weiteren Schritt und/oder die weiteren Schritte umfasst: Verändern der Konzentration der mindestens einen Komponente mittels des Getterelements aus einem reaktiven Material, durch chemische Bindung einer bestimmten Menge der Komponente an das Getterelement und/oder Verändern der Konzentration der mindestens einen Komponente mittels des Getterelements aus einem vorzugsweise inerten Material, durch physikalische Bindung einer bestimmten Menge der Komponente an das Getterelement. Gemäß einer Ausgestaltung weist die Einrichtung zum Steuern mindestens eine Einrichtung zur Temperatursteuerung und/oder -regelung auf, wobei das Verfahrne den weiteren Schritt umfasst: Steuern der Temperatur mindestens des wirksamen Bereichs des Getterelements und/oder des Gegenstands, insbesondere des Substrats, mittels der Einrichtung zur Temperatursteuerung oder -regelung. Gemäß einer Ausgestaltung weist die Einrichtung zum Steuern mindestens ein Blendenelement und/oder eine Einrichtung zum Verfahren und/oder Positionieren des Getterelements und/oder des Blendenelements auf, wobei das Verfahren den weiteren Schritt und/oder die weiteren Schritte umfasst: Variieren eines wirksamen Bereichs des Getterelements mittels des mindestens einen Blendenelements und/oder Verfahren und/oder Positionieren des Getterelements und/oder des Blendenelements in der Abscheidekammer mittels der Einrichtung zum Verfahren und/oder Positionieren des Getterelements und/oder des Blendenelements.

### Bezugszeichenliste

- 10: Vorrichtung zum Abscheiden
- 11: Abscheideraum, Rezipient
- 12: Quelle
- 20: Substrat, Gegenstand allgemein
- 21: "Nacktes" Substrat
- 221: Schicht
- 222: Schicht
- 223: Schicht
- 224: Schicht
- 231: Schicht
- 232: Schicht
- 233: Schicht
- 234: Schicht
- 30: Abzuscheidendes Material
- 31: Dampfkeule
- 40: Einrichtung zum Steuern des Abscheidungsprozesses
- 41: Getterelement
- 41a: Getterelement
- 41b: Getterelement
- 41c: Getterelement
- 41d: Getterelement
- 42a: Blendenelement
- 42b: Blendenelement
- 42c: Blendenelement
- 42d: Blendenelement
- 43: Wirksamer Bereich
- 44: Einrichtung zur Temperatursteuerung oder -regelung
- 45: Einrichtung zum Verfahren und /oder Positionieren des Getterelements
- 46: Einrichtung zum Verschalten
- B: Bewegungsrichtung Blende und/oder Getterelement

## Patentansprüche

1. Vorrichtung (10) zum Abscheiden einer aus mindestens zwei Komponenten bestehenden Schicht auf einem Gegenstand (20), umfassend
- eine Abscheidekammer (11) zum Anordnen des Gegenstands (20),
- mindestens eine Quelle (12) mit abzuscheidendem Material (30),
- mindestens eine Einrichtung (40) zum Steuern des Abscheidungsprozesses, die derart ausgebildet ist, dass die Konzentration mindestens einer Komponente des abzuscheidenden Materials in deren Gasphase vor Abscheidung auf den Gegenstand (20) durch selektive Bindung einer bestimmten Menge der mindestens einen Komponente veränderbar ist, wobei die selektiv gebundene Menge der mindestens einen Komponente durch Veränderung zumindest eines mit einer Bindungsrate für die wenigstens eine Komponente wirkgekoppelten Steuerparameters steuerbar ist, wobei die Einrichtung (40) zum Steuern des Abscheidungsprozesses mindestens ein Getterelement (41, 41a, 41b, 41c, 41d) aus einem gegenüber der mindestens einen zu steuernden Komponente chemisch inerten oder chemisch reaktiven Material aufweist, das in der Abscheidekammer (11) angeordnet und so ausgebildet ist, dass die Konzentration der mindestens eine Komponente durch physikalische oder chemische Bindung einer bestimmten Menge der Komponente an das Getterelement (41, 41a, 41b, 41c, 41d) veränderbar ist, wobei die Einrichtung (40) so ausgebildet ist, dass eine wirksame Bindungsfläche veränderbar ist, wobei die Einrichtung (40) zum Steuern des Abscheidungsprozesses mindestens ein Blendenelement (42a, 42b, 42c, 42d) für das Getterelement aufweist, das derart ausgebildet ist, dass ein wirksamer Bereich des Getterelements (41, 41a, 41b, 41c, 41d) variierbar ist, und/oder ein elektrisches Potenzial des Getterelements (41, 41a, 41b, 41c, 41d) veränderbar ist.

2. Vorrichtung (10) nach Anspruch 1, bei welcher die Einrichtung (40) zum Steuern des Abscheidungsprozesses so ausgebildet ist, dass die selektiv gebundene Menge der mindestens einen Komponente während des Abscheidungsprozesses der Komponente steuerbar ist.

3. Vorrichtung (10) nach einem der Ansprüche 1 oder 2, bei welcher die Einrichtung (40) zum Steuern des Abscheidungsprozesses mindestens zwei Getterelemente (41, 41a, 41b, 41c, 41d) aufweist, die als Elektrodenelemente ausgebildet sind, an die unterschiedliche elektrische Potentiale anlegbar sind, so dass zwei unterschiedlich ausgebildete Getterelemente vorgesehen sind.

4. Vorrichtung (10) nach einem der Ansprüche 1 bis 3, bei welcher die Einrichtung (40) zum Steuern des Abscheidungsprozesses so ausgebildet ist, dass an das mindestens eine Getterelement (41, 41a, 41b, 41c, 41d) in Bezug auf eine Wandung der Abscheidekammer (11) ein unterschiedliches elektrisches Potential anlegbar ist.

5. Vorrichtung (10) nach einem der Ansprüche 1 bis 4, bei welcher die Einrichtung (40) zum Steuern des Abscheidungsprozesses mindestens eine Elektrode aufweist und so ausgebildet ist, dass an das Getterelement (41, 41a, 41b, 41c, 41d) in Bezug auf diese Elektrode ein unterschiedliches elektrisches Potential anlegbar ist.

6. Vorrichtung (10) nach einem der Ansprüche 1 bis 5, bei welcher die Einrichtung (40) zum Steuern des Abscheidungsprozesses mindestens eine Einrichtung (45) zum Verfahren und/oder Positionieren des Getterelements (41, 41a, 41b, 41c, 41d) und/oder eines Blendenelements (42a, 42b, 42c, 42d) für das Getterelement aufweist, die derart ausgebildet ist, dass das Getterelement (41, 41a, 41b, 41c, 41d) und/oder das Blendenelement (42a, 42b, 42c, 42d) in der Abscheidekammer (11) verfahrbar und so die Position des Getterelements (41, 41a, 41b, 41c, 41d) und/oder des Blendenelements (42a, 42b, 42c, 42d) variierbar ist.

7. Vorrichtung (10) nach einem Ansprüche 1 bis 6, bei welcher das Getterelement (41, 41a, 41b, 41c, 41d) als ein Flächenelement und/oder Stabelement und/oder Gitterelement ausgebildet ist und/oder das Getterelement (41, 41a, 41b, 41c, 41d) so ausgebildet ist, dass es die Quelle (12) mindestens teilweise umhüllt.

8. Vorrichtung (10) nach einem der Ansprüche 1 bis 7, bei welcher das Getterelement (41, 41a, 41b, 41c, 41d) in der Abscheidekammer (11) angeordnet ist und/oder mindestens einen Teil der Abscheidekammer (10) ausbildet.

9. Vorrichtung (10) nach einem der Ansprüche 1 bis 8, bei welcher das reaktive Material des Getterelements (41, 41a, 41b, 41c, 41d) Kupfer und/oder Molybdän umfasst.

10. Verfahren zum Abscheiden einer aus mindestens zwei Komponenten bestehenden Schicht auf einem Gegenstand (20), bei welchem die Konzentration mindestens einer Komponente in deren Gasphase vor Abscheidung auf dem Gegenstand durch selektive Bindung einer bestimmten Menge der Komponente mittels einer Einrichtung (40) zum Steuern des Abscheidungsprozesses verändert wird, wobei die selektiv gebundene Menge durch Veränderung einer Bindungsrate für die Komponente der Einrichtung (40) zum Steuern des Abscheidungsprozesses gesteuert wird, wobei die selektiv gebundene Menge der mindestens einen Komponente durch Verändern einer wirksamen Bindungsfläche durch mindestens ein Blendenelement (42a, 42b, 42c, 42d) für das Getterelement und/oder eines elektrischen Potenzial eines Getterelements (41, 41a, 41b, 41c, 41d) gesteuert wird.

11. Verwendung einer Vorrichtung nach einem der Ansprüche 1 bis 9, sowie eines Verfahrens nach Anspruch 10 zur Herstellung einer Dünnschichtsolarzelle bzw. Dünnschichtsolarmoduls, insbesondere einer CIS(CIGSSe)-Dünnschichtsolarzelle bzw. eines CIS(CIGSSe)-Dünnschichtsolarmoduls.

## Claims

1. A device (10) for depositing a layer consisting of at least two components on an object (20), comprising
- a deposition chamber (11) for disposing the object (20),
- at least one source (12) comprising a material to be deposited (30),
- at least one apparatus (40) for controlling the deposition process, configured such that the concentration of at least one component of the material to be deposited in its gas phase can be modified prior to deposition onto the object (20) by selective binding of a certain amount of the at least one component, wherein the selectively bound amount of the at least one component can be controlled by modifying at least one control parameter operatively coupled to a binding rate for the at least one component, wherein the apparatus (40) for controlling the deposition process has at least one gettering element (41, 41a, 41b, 41c, 41d) made of a material chemically inert to or chemically reactive with the at least one component to be controlled, which is arranged in the deposition chamber (11) and is configured such that the concentration of the at least one component can be modified by physical or chemical binding of a certain amount of the component to the gettering element (41, 41a, 41b, 41c, 41d), wherein the apparatus (40) is configured such that an effective binding area can be modified, wherein the apparatus (40) for controlling the deposition process has at least one masking element (42a, 42b, 42c, 42d) for the gettering element, which is configured such that an effective area of the gettering element (41, 41a, 41b, 41c, 41d) can be varied, and/or an electric potential of the gettering element (41, 41a, 41b, 41c, 41d) can be modified.

2. The device (10) of claim 1, wherein the apparatus (40) for controlling the deposition process is configured such that the selectively bound amount of the at least one component can be controlled during the deposition process of the component.

3. The device (10) of any of claims 1 or 2, wherein the apparatus (40) for controlling the deposition process has at least two gettering elements (41, 41a, 41b, 41c, 41d) which are configured as electrode elements to which different electrical potentials can be applied, so that two differently configured gettering elements are provided.

4. The device (10) of any of claims 1-3, wherein the apparatus (40) for controlling the deposition process is configured such that a different electrical potential can be applied to the at least one gettering element (41, 41a, 41b, 41c, 41d) relative to a wall of the deposition chamber (11).

5. The device (10) of any of claims 1-4, wherein the apparatus (40) for controlling the deposition process has at least one electrode and is configured such that a different electrical potential can be applied to the gettering element (41, 41a, 41b, 41c, 41d) relative to said electrode.

6. The device (10) of any of claims 1-5, wherein the apparatus (40) for controlling the deposition process has at least one apparatus (45) for moving and/or positioning the gettering element (41, 41a, 41b, 41c, 41d) and/or a masking element (42a, 42b, 42c, 42d) for the gettering element, which is configured such that the gettering element (41, 41a, 41b, 41c, 41d) and/or the masking element (42a, 42b, 42c, 42d) in the deposition chamber (11) can be moved and thus the position of the gettering element (41, 41a, 41b, 41c, 41d) and/or the masking element (42a, 42b, 42c, 42d) can be varied.

7. The device (10) of any of claims 1-6, wherein the gettering element (41, 41a, 41b, 41c, 41d) is configured as a surface element and/or rod element and/or grid element and/or the gettering element (41, 41a, 41b, 41c, 41d) is configured such that it at least partially encloses the source (12).

8. The device (10) of any of claims 1-7, wherein the gettering element (41, 41a, 41b, 41c, 41d) is arranged in the deposition chamber (11) and/or forms at least part of the deposition chamber (10).

9. The device (10) of any of claims 1-8, wherein the reactive material of the gettering element (41, 41a, 41b, 41c, 41d) comprises copper and/or molybdenum.

10. A method of depositing a layer consisting of at least two components on an object (20), wherein the concentration of at least one component in its gas phase is modified prior to deposition on the object by selective binding of a certain amount of the component by means of an apparatus (40) for controlling the deposition process, wherein the selectively bound amount is controlled by modifying a binding rate for the component of the apparatus (40) for controlling the deposition process, wherein the selectively bound amount of the at least one component is controlled by modifying an effective binding area through at least one masking element (42a, 42b, 42c, 42d) for the gettering element and/or an electrical potential of a gettering element (41, 41a, 41b, 41c, 41d).

11. Use of a device of any of claims 1-9 and a method of claim 10 for producing a thin-film solar cell or thin-film solar module, in particular a CIS(CIGSSe) thin-film solar cell or a CIS(CIGSSe) thin-film solar module.

## Revendications

1. Dispositif (10) pour déposer une couche composée d'au moins deux constituants sur un objet (20), comportant :
- une chambre de dépôt (11) recevant ledit objet (20),
- au moins une source (12) de matière à déposer (30), et
- au moins un dispositif (40) de commande du processus de dépôt, conçu de telle manière que la concentration d'au moins un constituant de ladite matière à déposer peut être modifiée dans la phase gazeuse du constituant, avant le dépôt sur ledit objet (20), par liaison sélective d'une quantité définie dudit au moins un constituant, **caractérisé en ce que**, la quantité sélectivement liée dudit au moins un constituant peut être commandée par modification d'au moins un paramètre de commande couplé de manière opérationnelle à une vitesse de liaison dudit au moins un constituant ; ledit dispositif (40) de commande du processus de dépôt comporte au moins un élément getter (41, 41a, 41b, 41c, 41d) composé de matière chimiquement inerte ou chimiquement réactive par rapport audit au moins un constituant à commander, qui est disposé dans ladite chambre de dépôt (11) et est conçu de telle manière que la concentration dudit au moins un constituant peut être modifiée par liaison physique ou chimique d'une quantité définie dudit constituant audit élément getter (41, 41a, 41b, 41c, 41d ; ledit dispositif (40) est conçu de telle manière qu'une zone de liaison efficace peut être modifiée ; et ledit dispositif (40) de commande du processus de dépôt présente au moins un élément de masquage (42a, 42b, 42c, 42d) pour ledit élément getter, qui est conçu de telle manière qu'une zone efficace dudit élément getter (41, 41a, 41b, 41c, 41d) peut être modifiée, et/ou qu'un potentiel électrique dudit élément getter (41, 41a, 41b, 41c, 41d) peut être modifié.

2. Dispositif (10) selon la revendication 1, **caractérisé en ce que**, ledit dispositif (40) de commande du processus de dépôt est conçu de manière sorte que la quantité sélectivement liée dudit au moins un constituant peut être commandée pendant le processus de dépôt dudit constituant.

3. Dispositif (10) selon l'une quelconque des revendications 1 ou 2, **caractérisé en ce que**, ledit dispositif (40) de commande du processus de dépôt présente au moins deux éléments getters (41, 41a, 41b, 41c, 41d) qui sont conçus comme des éléments d'électrode auxquels peuvent être appliqués des potentiels électriques différents, de sorte que lesdits deux éléments getters différemment conçus sont prévus.

4. Dispositif (10) selon l'une quelconque des revendications 1 à 3, **caractérisé en ce que**, ledit dispositif (40) de commande du processus de dépôt est conçu de telle manière qu'un potentiel électrique différent peut être appliqué audit au moins un élément getter (41, 41a, 41b, 41c, 41d) par rapport à une paroi de ladite chambre de dépôt (11).

5. Dispositif (10) selon l'une quelconque des revendications 1 à 4, **caractérisé en ce que**, ledit dispositif (40) de commande du processus de dépôt comporte au moins une électrode et est conçu de telle manière qu'un potentiel électrique différent peut être appliqué audit élément getter (41, 41a, 41b, 41c, 41d) par rapport à ladite électrode.

6. Dispositif (10) selon l'une quelconque des revendications 1 à 5, **caractérisé en ce que**, ledit dispositif (40) de commande du processus de dépôt comporte au moins un dispositif de déplacement (45) et/ou de positionnement dudit élément getter (41, 41a, 41b, 41c, 41d) et/ou un élément de masquage (42a, 42b, 42c, 42d) pour ledit élément getter, qui est conçu de telle manière que ledit élément getter (41, 41a, 41b, 41c, 41d) et/ou ledit élément de masquage(42a, 42b, 42c, 42d) dans ladite chambre de dépôt (11) peut être déplacé et que la position dudit élément getter (41, 41a, 41b, 41c, 41d) et/ou dudit élément de masquage (42a, 42b, 42c, 42d) peut être ainsi modifiée.

7. Dispositif (10) selon l'une quelconque des revendications 1 à 6, **caractérisé en ce que**, ledit élément getter (41, 41a, 41b, 41c, 41 d) est conçu comme un élément de surface et/ou un élément de tige et/ou un élément de grille, et/ou ledit élément getter (41, 41a, 41b, 41c, 41 d) est conçu de telle manière qu'il enveloppe au moins partiellement ladite source (12).

8. Dispositif (10) selon l'une quelconque des revendications 1 à 7, **caractérisé en ce que**, ledit élément getter (41, 41a, 41b, 41c, 41 d) est disposé dans ladite chambre de dépôt (11) et/ou forme au moins une partie de ladite chambre de dépôt (10).

9. Dispositif (10) selon l'une quelconque des revendications 1 à 8, **caractérisé en ce que**, ladite matière réactive dudit élément getter (41, 41a, 41b, 41c, 41d) comprend du cuivre et/ou du molybdène.

10. Procédé de dépôt d'une couche composée d'au moins deux constituants sur un objet (20), **caractérisé en ce que**, la concentration dudit au moins un constituant peut être modifiée dans la phase gazeuse du constituant, avant le dépôt sur ledit objet, par liaison sélective d'une quantité définie dudit au moins un constituant au moyen dudit dispositif (40) de commande du processus de dépôt ; la quantité sélectivement liée est commandée par modification d'une vitesse de liaison pour ledit constituant dudit dispositif (40) de commande du processus de dépôt ; la quantité sélectivement liée dudit au moins un constituant est commandée par modification d'une zone de liaison efficace à travers ledit au moins un élément de masquage (42a, 42b, 42c, 42d) pour ledit élément getter et/ou d'un potentiel électrique d'un élément getter (41, 41a, 41b, 41c, 41d).

11. Utilisation d'un dispositif selon l'une quelconque des revendications 1 à 9 ainsi que d'un procédé selon la revendication 10, pour la fabrication d'une cellule solaire à couche mince ou d'un module solaire à couche mince, en particulier d'une cellule solaire à couche mince CIS(CIGSSe) ou d'un module solaire à couche mince CIS(CIGSSe).
